Europäisches Patentamt

European Patent Office

Office européen des brevets

(19)

(11) Numéro de publication : **0 660 426 A1**

# (12) DEMANDE DE BREVET EUROPEEN

(21) Numéro de dépôt : **94403002.2**

(22) Date de dépôt : **23.12.94**

(51) Int. Cl.[6] : **H01L 39/20, H01F 6/06**

(30) Priorité : **27.12.93 FR 9315695**

(43) Date de publication de la demande :
**28.06.95 Bulletin 95/26**

(84) Etats contractants désignés :
**CH DE ES FR GB IT LI NL SE**

(71) Demandeur : **ALCATEL ALSTHOM COMPAGNIE GENERALE D'ELECTRICITE
54, rue La Boétie
F-75008 Paris (FR)**

(72) Inventeur : **Verhaege, Thierry
22, Allée Georges Brassens
F-91160 Saulx Les Chartreux (FR)**
Inventeur : **Herrmann, Peter Friedrich
1 Impasse des Fleurs,
Dourdan
F-91410 Corbreuse (FR)**

(74) Mandataire : **Fournier, Michel et al
SOSPI
14-16, rue de la Baume
F-75008 Paris (FR)**

(54) **Limiteur de courant.**

(57)     Limiteur de courant comprenant un conducteur supraconducteur à haute température critique (HTc) comme par exemple une céramique du type $Bi_2Sr_2Ca_1Cu_2O_8$ (en abrégé BSCCO) caractérisé en ce que la section (S) du conducteur et sa température de fonctionnement (T) sont telles que les relations suivantes soient vérifiées :

$$\rho_T(j) \cdot j > 10^{-4}$$
$$\frac{\rho_T(5j)}{\rho_T(j)} > 100$$
$$10^8 < \rho_T(5j) \cdot j^2 < 10^{10}$$

dans lesquelles :

$\rho_T$ est la résistivité apparente du matériau HTc, qui est une fonction de la densité de courant et de la température T de fonctionnement,

j est la valeur de la densité de courant pour la valeur crête $Ic = In\sqrt{2}$,

soit $j = \dfrac{In\sqrt{2}}{S}$

FIG.1

EP 0 660 426 A1

La présente invention concerne un limiteur de courant résistif utilisant un matériau supraconducteur à haute température critique.

On rappelle qu'un limiteur de courant supraconducteur comprend un conducteur supraconducteur placé en série dans une ligne électrique à protéger; en régime normal, le conducteur est à l'état supraconducteur et présente une résistance négligeable; lorsque le courant dans la ligne, par suite d'un défaut tel qu'un court-circuit, dépasse la valeur critique du matériau supraconducteur, ce dernier transite à l'état résistif, ce qui limite automatiquement la valeur du courant de défaut. Le courant résiduel peut être coupé aisément par un disjoncteur qui n'a pas besoin d'avoir un pouvoir de coupure élevé.

Les limiteurs supraconducteurs résistifs utilisant des matériaux supraconducteurs à basse température critique (quelques K) ont fait l'objet d'études théoriques nombreuses et peuvent voir le jour industriellement dans les quelques années à venir. Ces limiteurs auront pour inconvénient la nécessité de maintenir leurs bobinnages à une température très basse, ce qui induit un coût d'exploitation relativement important.

L'apparition de matériaux supraconducteurs à haute température critique (de l'ordre de 100 K) a fait naître l'espoir de réaliser des limiteurs dont l'exploitation sera bien moins onéreuse, sachant que le coût de réfrigération à 77 K est environ 50 fois moins grand que le coût de réfrigération à 4,2 K.

La réalisation de limiteurs supraconducteurs en matériau supraconducteur à haute température (désigné dans la suite par matériau HTc) est cependant difficile car on ne sait réaliser actuellement que des blocs massifs ou des tubes, hormis les fils à matrice argent qui cependant ne conviennent pas car la forte conductivité de l'argent compromet l'effet limiteur.

Une autre difficulté réside dans le souci de limiter l'énergie dissipée dans le matériau HTc du limiteur lors de l'apparition d'une transition.

Ces problèmes ont été résolus par un choix des modalités d'emploi du matériau et par une technologie adaptée.

L'invention a pour objet un limiteur de courant comprenant un conducteur supraconducteur à haute température critique (HTc) comme par exemple une céramique du type $Bi_2Sr_2Ca_1Cu_2O_8$ (en abrégé BSCCO) caractérisé en ce que la section (S) du conducteur et sa température de fonctionnement (T) sont telles que les relations suivantes soient vérifiées:

$$\rho_T(j).\, j > 10^{-4}$$
$$\frac{\rho_T(5j)}{\rho_T(j)} > 100$$
$$10^8 < \rho_T(5j).j^2 < 10^{10}$$

dans lesquelles:

$\rho_T$ est la résistivité apparente du matériau HTc, qui est une fonction de la densité de courant et de la température T de fonctionnement,

j est la valeur de la densité de courant pour la valeur crête $Ic = In\sqrt{2}$,

$$\text{soit } j = \frac{In\sqrt{2}}{S}$$

Dans un premier mode de réalisation, le limiteur comprend une pluralité d'hélices usinées dans des tubes matériau supraconducteur à haute température critique, comme par exemple la céramique BSCCO, coaxiaux, les hélices étant connectées en série.

En variante, le limiteur comprend une pluralité de conducteurs usinés dans des plaques de matériau supraconducteur à haute température critique, comme par exemple la céramique BSCCO, parallèles, les conducteurs étant connectés en série. Avantageusement, les conducteurs sont obtenus par une série de sciages parallèles et rectilignes pratiqués dans lesdites plaques.

Dans les deux variantes de réalisation, les parties en matériau supraconducteur à haute température critique sont plongées dans l'azote liquide en dépression.

L'invention est expliquée maintenant plus en détail et on se référera au dessin annexé dans lequel:

- la figure 1 est un diagramme représentant, pour diverses températures, les variations de la résistivité d'une céramique BSCCO en fonction de la densité de courant qui la traverse,
- la figure 2 est une vue schématique en perspective du conducteur d'un limiteur supraconducteur HTc selon un premier mode de réalisation de l'invention,
- la figure 3 est une vue schématique en perspective du conducteur d'un limiteur supraconducteur HTC selon un second mode de réalisation de l'invention.

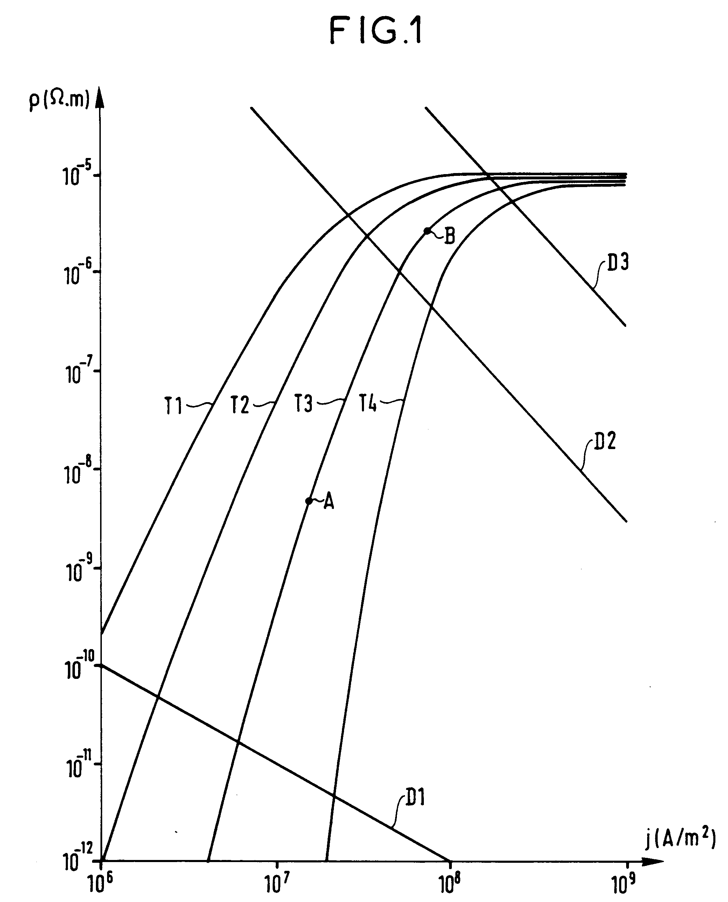

Le diagramme de la figure 1 représente, pour diverses températures T1, T2, T3, T4, les variations de la résistivité $\rho$, exprimée en $\Omega.m$, typique d'un matériau BSCCO, en fonction de la densité j du courant qui le traverse, exprimée en $A/mm^2$.

Dans l'exemple de la figure, T1 = 77 K, T2 = 72 K, T3 = 67K et T4 = 62 K.

Le point A correspond au régime nominal de fonctionnement du limiteur. Le point B correspond au régime de limitation.

La droite D1 est la limite supérieure habituellement considérée pour un fonctionnement à l'état supraconducteur, cette droite étant définie par la relation:

$$E = \rho.\, jc = 10^{-4}\, V/m$$

dans laquelle jc est la densité de courant critique.

L'invention propose que le point $A(j, \rho(j))$ se situe au-dessus de la droite D1, ce qui est un mode de fonctionnement non classique pour un supraconducteur.

La droite D2 a pour équation $\rho(5j).j^2 = 10^8$ correspondant au traitement d'une puissance volumique de

0,25 MVA/I; pour que le limiteur ait une compacité suffisante, l'invention propose que le point B(5j, $\rho$(5j)) se situe au-dessus de la droite D2.

La droite D3 a pour équation $\rho$(5j).j² = 10¹⁰ correspondant au traitement d'une puissance volumique (produit de la tension nominale par le courant nominal) de 25 MVA/I; pour pouvoir aisément protéger le matériel d'une surchauffe excessive, l'invention propose que le point B soit situé au-dessous de D3.

La dernière condition impose que le rapport des résistivités en B et en A soit supérieur à 100. Cette condition ne peut être vérifiée à la température T1, où les variations de $\rho$ en fonction de j sont trop lentes. Elle commence à être réalisable à la température T2, mais on préférera la température T3 qui permet par exemple de traiter 1,3 MVA/I avec $\rho$(B)/$\rho$(A) = 500, soit des pertes résistives au nominal ne dépassant pas 0,04%, ou un coût cryogénique ne dépassant pas 0,6%.

La température T3 = 67 K peut être atteinte aisément à l'aide d'un bain d'azote en dépression; elle sera préférée à la température T4 = 62 K, qui ne peut être atteinte avec l'azote liquide, et n'apporte pas d'avantage majeur sur la caractéristique exploitable du BSCCO. Il est toutefois possible d'atteindre ces températures à l'aide d'un cryoréfrigérateur.

Un exemple de réalisation du limiteur selon l'invention fonctionnera donc entre les points A et B du diagramme, avec les valeurs ci-après:

en A, T3 = 67 K    $j_A$ = 15 A/mm²    $\rho_A$ = 4,6.10⁻⁹ W.m

en B, T3 = 67 K    $j_B$ = 5$j_A$= 75A/mm²    $\rho_B$ = 500 $\rho_A$ = 2,3.10⁻⁶ $\Omega$.m

Pour dimensionner par exemple un limiteur opérant sous une tension nominale Un de 36 kV et avec un courant nominal In de 1,25 kA, limitant la valeur du courant de défaut à 5In, soit 6,25 kA, on choisira:
- une section S = In $\sqrt{2}$/$j_A$ = 118 mm²
- une longueur l = Un$\sqrt{2}$/$\rho_B$.$j_B$ = 295 m

Le volume de matière est v = S.l = 34,8 litres, soit une puissance volumique traitée P = UnIn/v de 1,3 MVA/I.

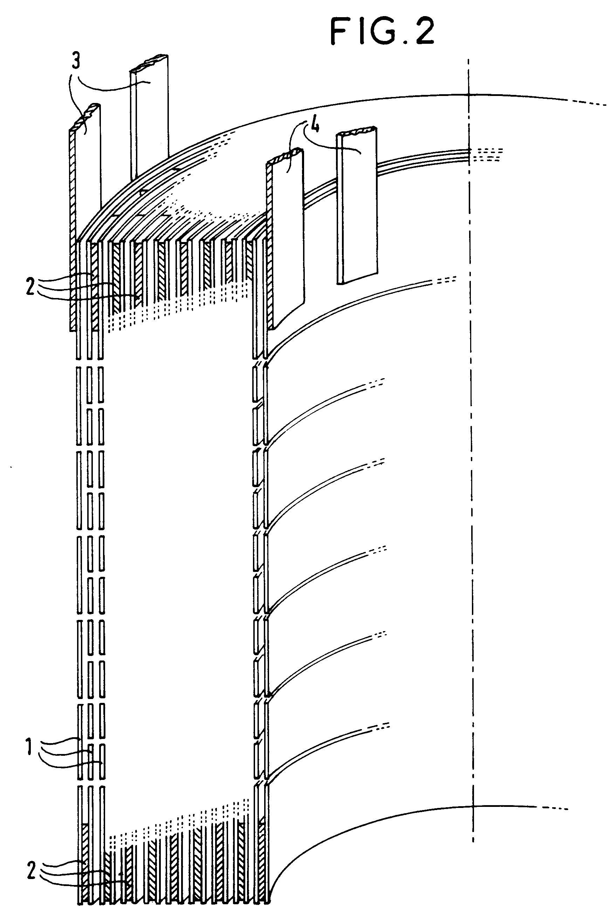

La figure 2 représente un premier exemple de réalisation d'un limiteur par usinage sous forme d'hélices d'un nombre pair de tubes 1 de BSCCO, minces, coaxiaux, de même hauteur. Les extrémités des hélices comportent des surfaces de contact 2, par exemple en argent, permettant le mise en série des diverses hélices. Des connexions 3 sur le tube extérieur et 4 sur le tube intérieur permettent l'amenée et le départ du courant. Le pas des hélices formées dans le premier et le dernier tubes est avantageusement deux fois plus grand que le pas des hélices formées dans les autres tubes, afin de minimiser le champ magnétique produit à l'extérieur du dispositif.

L'ensemble ci-dessus est plongé dans un bain d'azote liquide maintenu en dépression ou refroidi par un cryoréfrigérateur; la chaleur est extraite par convection naturelle dans les espaces entre les hélices.

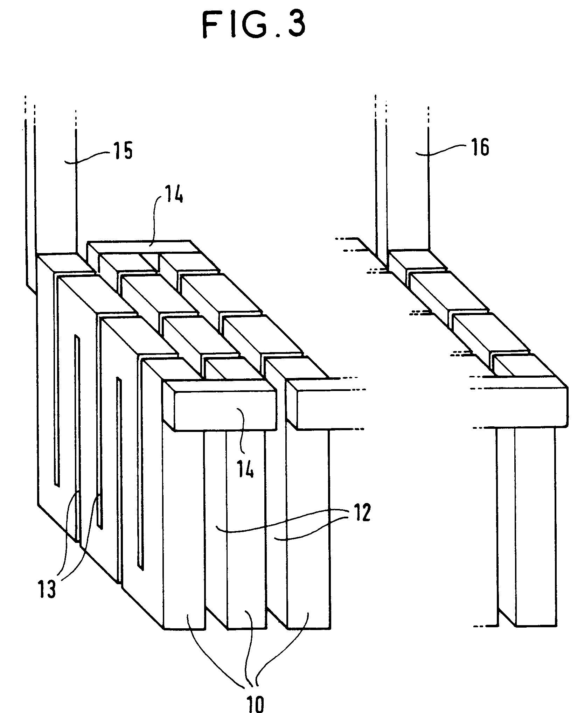

Dans le mode de réalisation de la figure 3, des plaques 10 de BSCCO, verticales, parallèles, identiques séparées l'une de l'autre par un espace 12, sont usinées de manière à constituer chacune un conducteur ayant une section de passage constante calculée comme indiqué plus haut. L'usinage est avantageusement fait de traits rectilignes 13.

Les conducteurs usinés dans les plaques sont mis en série électriquement par des connexions 14 par exemple en argent. Les plaques d'extrémités sont munies de connexion, respectivement 15 et 16 pour l'amenée et le départ du courant.

Comme précédemment, l'ensemble est plongé dans un bain d'azote liquide ou refroidi par un cryoréfrigérateur.

L'invention s'applique à la réalisation de dispositifs de protection électrique à moyenne et haute tension.

**Revendications**

1/ Limiteur de courant comprenant un conducteur supraconducteur à haute température critique (HTc) comme par exemple une céramique du type $Bi_2Sr_2Ca_1Cu_2O_8$ (en abrégé BSCCO) caractérisé en ce que la section (S) du conducteur et sa température de fonctionnement (T) sont telles que les relations suivantes soient vérifiées:

$\rho_T$(j). j > 10⁻⁴

$\dfrac{\rho_T(5j)}{\rho_T(j)} > 100$

10⁸ < $\rho_T$(5j).j² < 10¹⁰

dans lesquelles:
$\rho_T$ est la résistivité apparente du matériau HTc, qui est une fonction de la densité de courant et de la température T de fonctionnement,

j est la valeur de la densité de courant pour la valeur crête Ic = In$\sqrt{2}$,

soit $j = \dfrac{In\sqrt{2}}{S}$

2/ Limiteur selon la revendication 1, caractérisé en ce qu'il comprend une pluralité d'hélices usinées dans des tubes (1) en matériau supraconducteur à haute températue critique comme par exemple une céramique BSCCO, coaxiaux, les hélices étant connectées en série.

3/ Limiteur selon la revendication 1, caractérisé en ce qu'il comprend une pluralité de conducteurs usinés dans des plaques (10) en matériau supraconducteur à haute températue critique comme par exemple une céramique BSCCO, parallèles, les conducteurs étant connectés en série.

4/ Limiteur selon la revendication 3, caractérisé en ce que les conducteurs sont obtenus par une série de sciages parallèles et rectilignes pratiqués dans lesdites plaques.

**5/** Limiteur selon l'une des revendications 1 à 4, caractérisé en ce que les parties en BSCCO sont plongées dans l'azote liquide en dépression.

**6/** Limiteur selon l'une des revendications 1 à 4, caractérisé en ce que les parties en BSCCO sont refroidies par un cryoréfrigérateur.

# FIG.1

# FIG.2

# FIG.3

EP 0 660 426 A1

**Office européen des brevets**

**RAPPORT DE RECHERCHE EUROPEENNE**

Numero de la demande
EP 94 40 3002

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | EP-A-0 315 976 (TOSHIBA)<br>* colonne 4, ligne 14 – colonne 5, ligne 17; figure 3 *<br>--- | 1 | H01L39/20<br>H01F6/06 |
| A | EP-A-0 472 333 (HITACHI)<br>* page 12, ligne 6 – ligne 10; figure 21 *<br>----- | 1 | |

**DOMAINES TECHNIQUES RECHERCHES (Int.Cl.6)**

H01L
H01F
H02H

Le présent rapport a été établi pour toutes les revendications

| Lieu de la recherche | Date d'achèvement de la recherche | Examinateur |
|---|---|---|
| LA HAYE | 4 Avril 1995 | Salm, R |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

........................................................................................
& : membre de la même famille, document correspondant

EPO FORM 1503 03.82 (P04C02)

8